# EUROPÄISCHE PATENTANMELDUNG

(11) **EP 2 009 965 A1**
(43) Veröffentlichungstag der Anmeldung: **31.12.2008**
(21) Anmeldenummer: 08016741.4
(22) Anmeldetag: 17.03.2001
(51) Int. Cl.: H05K 1/02

(54) **Trägersubstrat für elektronische Bauteile**

(30) Priorität: 20.04.2000 DE 10019888
(62) Teilanmeldung aus: 01925483.8
(71) Anmelder: Schott Glas, 55122 Mainz (DE)
(72) Erfinder: Zenker, Thomas, Dr., 55268 Nieder-Olm (DE); Thiemann, Christian, 55126 Mainz (DE)
(74) Vertreter: Sawodny, Michael-Wolfgang

(57) **Zusammenfassung**

15. Die Erfindung betrifft ein Trägersubstrat für elektronische Bauteile, insbesondere Leuchtmittel, die auf einer Fläche des Trägersubstrates aufgebracht sind mit
- einem transparenten Substrat (1)
- einer auf das transparente Substrat (1) aufgebrachten leitfähigen Schicht **dadurch gekennzeichnet, dass**
- die leitfähige Schicht im sichtbaren Wellenlängenbereich transparent oder quasitransparent und beliebig struktuierbar ist

## Beschreibung

Die Erfindung betrifft ein Trägersubstrat für elektronische Bauteile, insbesondere für Leuchtmittel, die auf einer Fläche des Trägersubstrates aufgebracht werden, mit einem transparenten Substrat sowie einer auf das transparente Substrat aufgebrachten leitfähigen Schicht sowie ein elektronisches Bauelement mit einem derartigen Trägersubstrat und ein Verfahren zur Herstellung eines derartigen elektronischen Bauelementes.

Leuchtdioden, sogenannte LED's eignen sich für eine Vielzahl von Anwendungen in der Beleuchtungstechnik. Sogenannte LED-Module umfassen eine Vielzahl von Leuchtdioden auf einem Trägersubstrat. Die auf dem Trägersubstrat angeordneten Leuchtdioden bilden wiederum eine Anzeigeeinheit, die beispielsweise für die Anzeige von Zielorten in einem Bus dienen kann. Eine derartige Anzeigematrix ist aus der DE-A-19729469 bekannt geworden. Bei der Anzeigeeinnchtung gemäß der DE-A-19729469 werden die Leuchtdioden auf einer transparenten Folie angeordnet, wobei die Folie Leiterbahnen für die Energieversorgung der Lichtquellen umfaßt. Gemäß der DE-A-19729469 werden die Leiterbahnen zur Energieversorgung der LED-Dioden durch eine leitende Paste oder Flüssigkeit hergestellt, die undurchsichtig ist und auf transparente Folie aufgedruckt oder hieran befestigt werden.

Vorzugsweise sind die Leiterbahnen gemäß der DE-A-19729469 in Matrixform angeordnet.

Die Kontaktierung der einzelnen Leuchtdioden auf den Leiterbahnen wird mit leitendem Kleber vorgenommen.

Nachteilig an der Anzeigevorrichtung gemäß der DE-A-19729469 ist, daß die Leiterbahn, die auf dem transparenten Substrat aufgebracht werden, undurchsichtig sind. Ein weiterer Nachteil ist das aufwendige Aufbringen auf das durchsichtige Substrat beispielsweise durch Befestigen oder Aufdrucken.

Aus der EP-A- 0900971 ist eine Beleuchtungsvorrichtung mit Leuchtdioden bekannt geworden, die aus einer Vielzahl von auf der Fläche einer Glasplatte befestigten Leuchtdioden umfaßt. Die Leuchtdioden sind mit auf der Glasplatte angebrachten, als dünne und unsichtbare Schicht ausgebildeten Leiterbahnen elektrisch verbunden. Die Leiterbahnen und deren Anschlüsse sind auf der gleichen Fläche der Glasplatte angebracht, auf der sich auch die Leuchtdioden befinden.

Gemäß der EP-A-0900971 werden die Leiterbahnen durch Verdampfen von Metall auf die Glasplatte aufgebracht, wobei bereits vor dem Aufdampfen eine entsprechende Maskierung verwendet wird.

Nachteilig an der Beleuchtungsvorrichtung gemäß der EP-A-0900971 ist, daß die Leiterbahnen bereits beim Aufdampfprozeß strukturiert werden.

Weitere Nachteile der Systeme gemäß dem Stand der Technik waren, daß diese kein Löten auf durchsichtigen Leiterbahnen erlaubten sowie keine dreidimensionale Formgebung, da die leitfähigen Schichten bei Formgebungsprozessen wie beispielsweise Biegen abplatzten.

Aufgabe der Erfindung ist es, ein Trägersubstrat für elektronische Bauteile, insbesondere für Leuchtdioden bzw. LED-Module umfassend mehrere Leuchtdioden anzugeben, daß zum einen die erforderliche Transparenz sicherstellt, zum anderen sehr kostengünstig herzustellen ist und den hohen Fertigungsaufwand der Systeme gemäß dem Stand der Technik vermeidet. Erfindungsgemäß wird diese Aufgabe durch ein Trägersubstrat gelöst, bei dem die auf das transparente Substrat aufgebrachte leitfähige Schicht im sichtbaren Wellenlängenbereich transparent oder quasitransparent und beliebig strukturierbar ist. Zur Herstellung transparenter Leiterbahnen finden bevorzugt Metalloxide Verwendung, beispielsweise ITO (InOₓ:Sn), FTO (SnOₓ:F) oder ATO (SnOₓ:Sb). Denkbar sind aber auch ZnOₓ:Ga, ZnOₓ:F, ZnOₓ : B, ZnOₓ:Al oder Ag/TiOₓ.

Der Auftrag dieser Schicht auf das transparente Substrat erfolgt vorzugsweise mittels Chemical Vapor Deposition (CVD) oder Physical Vapor Deposition (PVD), Tauchbeschichtung, chemisch oder elektrochemische Beschichtung.

Nur beispielsweise seien hier die Sprühpyrolyse, das Sputtern oder Sol-Gel-Verfahren genannt. Das Auftragen mittels Sprühpyrolyse ist besonders kostengünstig, wobei als Beschichtungsmaterial bevorzugt ZnOₓ:F verwendet wird. Will man besonders hohe optische Eigenschaften erzielen, so ist das bevorzugte Auftragverfahren das Aufsputtern.

Im Gegensatz zum Stand der Technik können mit Hilfe der zuvor genannten Auftragverfahren Systeme mit beliebiger dreidimensionaler Form hergestellt werden. Hierzu wird zunächst das Substrat in die gewünschte dreidimensionale Form gebracht und anschließend das Auftragen der leitfähigen Schicht vorgenommen. Dies ermöglicht beispielsweise eine Applikation im Automobilbereich, z.B. die Fertigung beliebig geformter Amaturenbretter oder Heckleuchten.

Alternativ hierzu ist es auch möglich, daß die leitfähige Schicht aus einem aufgedampften oder aufgesputterten Metall wie Al, Ag, Au, Ni oder Cr, das in der Regel quasitransparent ist, besteht. Metallschichten finden bevorzugt bei hohen Umgebungstemperaturen Verwendung.

Unter transparenten Schichten bzw. Gläsern versteht man in der vorliegenden Anmeldung Schichten bzw. Gläser mit einer Transmission > 90 % im sichtbaren Wellenlängenbereich. Unter quasitransparenten Schichten bzw. Gläsern versteht man in der vorliegenden Anmeldung Schichten bzw. Gläser mit einer Transmission >60 %.

Um besonders reflexionsarme Systeme zu erhalten ist in einer Fortbildung der Erfindung vorgesehen, auf die leitfähige Schicht eine spezielle Reflexionsschicht aufzubringen, beispielsweise eine TiO₂ , SiO₂, oder eine Mischschicht aus TiₓSi₁₋ₓO₂.

Gemäß der Erfindung kann die leitende Schicht aus Metalloxid oder Metall nicht nur wie im Stand der Technik matrixförmig, sondern beliebig strukturiert werden. Dies ermöglicht das Aufbringen kompletter Strukturen wie auf einlagigen PCB's (sogenannten Printed Circuit Boards). Dies wiederum erlaubt auf ein- und dasselbe Substrat volilständige elektronische Schaltung aufzubringen. Die Strukturierung der leitfähigen Schicht kann nach Aufbringen durch gezieltes Unterbrechen der Schicht beispielsweise mittels eines Lasers, der lokal die Beschichtung erhitzt und diese verdampft, vorgenommen werden. Bei Verwendung eines Lasers zum Einbringen der Strukturen in eine vollflächig aufgetragene leitfähige Schicht ist es vorteilhaft, wenn die Schicht im Bereich der Laserwellenlänge des eingesetzten Lasers eine besonders hohe Absorption aufweist und das Substrat für diese Wellenlänge transmissiv ist. Bei einem derartigen System erfolgt praktisch der gesamte Energieeintrag in die leitfähige Schicht und die Glasoberfläche weist nur geringe Verletzungen auf. Insbesondere können bei einem derartigen System Rißbildungen in der Glasoberfläche vermieden werden.

Alternativ hierzu ist die Strukturierung einer vollflächig aufgebrachten Schicht mit Hilfe von Lithographie und anschließenden Ätzprozessen möglich.

Eine Strukturierung ist aber auch denkbar in dem bereits beim Beschichten, beispielsweise beim Aufdampfen mit Hilfe von Maskentechniken die Leiterbahnen in der vorgegebenen Struktur aufgebracht werden.

Um die Leuchtdioden oder andere elektrische Bauteile auf den Trägersubstraten anzuschließen, können in einer bevorzugten Ausgestaltung der Erfindung Anschlußstellen, sogenannte Pads, auf die leitende Schicht aufgebracht werden. Derartige Anschlußstellen umfassen eine leitende Paste oder Lack, beispielsweise Silberleitlack oder Silberleitlackpaste. Das Aufbringen der einzelnen Anschlußstellen kann mittels Siebdruck oder Schablonendruck erfolgen und anschließendem Einbrennen, wobei ein derartiges Verfahren im Falle der Verwendung von Gläsern als transparentem Substrat gleichzeitig zum Vorspannen der Gläser genutzt werden kann. Ein Vorteil derart hergestellter Bauteile ist, daß besonders feste Gläser ohne einen zusätzlichen weiteren Bearbeitungsschritt erhalten werden können. Ein weiterer Vorteil liegt darin, daß durch das Aufbringen der Pads erstmals ein Löten auf einem transparenten Substrat ermöglicht wird. Im Stand der Technik erfolgte die Verbindung verschiedener Bauteile auf einem Substrat bei transparenten Leiterbahnen bislang stets durch Kleben. Ein Löten war nur auf undurchsichtigen Leiterbahnen möglich. Im Gegensatz zu Klebeverbindungen sind Lötverbindungen aber stabiler, langzeitbeständiger und unempfindlicher gegenüber Umwelteinflüssen, wie Luftfeuchtigkeit, Hitze, Chemikalien etc.

Zum Anschließen der Bauteile beziehungsweise Leuchtdioden an die leitfähige Schicht des Trägersubstrates über die Anschlußstellen kann die Bestückung des Trägersubstrates mit Leuchtdioden nach bekannten Standardverfahren aus der Elektronikindustrie erfolgen, indem beispielsweise mittels Schablonendruck auf die einzelnen Anschlußstellen beziehungsweise Anschlußpads Lötpaste aufgebracht werden. Daran anschließend werden die Leuchtdioden auf die Trägerplatte aufgebracht. Hierfür kann ein Chipbonder verwendet werden, der die einzelnen Leuchtmittel vor dem Lötprozeß auf dem Trägermaterial befestigt. Nach dem Befestigen der einzelnen Leuchtmittel wird das Trägersubstrat dann durch einen Reflow-Ofen verbracht. Alternativ hierzu können die mit einem Chipbonder bestückten LED's durch ein Wellenlötbad geschickt werden.

Gleichwohl ist es gemäß der Erfindung auch möglich, mittels Sieb- oder Schablonendruck auf das Trägersubstrat einen leitenden Kleber aufzubringen, so daß die Leuchtmittel beziehungsweise elektrischen Bauteile direkt auf dem Trägersubstrat aufgebracht werden können. Es kann sowohl isotrop leitender, wie auch anisotrop leitender Kleber verwandt werden. Bei sehr geringem Leiterbahnenabstand wird die Verwendung von anisotropem Kleber bevorzugt.

Der besondere Vorteil der vorliegende Erfindung ist die freie Strukturierbarkeit. Dies ermöglicht, daß auf dem Trägersubstrat nicht nur Leuchtmittel, beispielsweise Leuchtdioden wie im Stand der Technik aufgebracht werden können, sondern auch andere elektrische oder elektronische Bauteile. Hierbei kommen sämtliche bekannten elektrischen und elektronischen Bauteile in Betracht, beispielsweise diskrete Halbleiter, passive und aktive Bauelemente, Widerstände, Kondensatoren, Spulen etc.

Beispielsweise ist es dann möglich, daß zusätzlich zu den Leuchtdioden auch die gesamte Ansteuerelektronik auf dem Trägersubstrat aufgebracht wird.

In einer besonders bevorzugten Ausführungsform werden nicht nur einzelne elektrische oder elektronische Bauteile, wie z. B. Spulen oder Kondensatoren auf dem Trägersubstrat aufgebracht, sondern Zusatzplatinen oder Hybridschaltungen mit eigenständigen integrierten Schaltkreisen, die beispielsweise eine Stromquelle oder Stromsteuerung umfassen können. Bei der Ausbildung eines elektronischen Bauelementes, insbesondere eines LED-Moduls ist in einer bevorzugten Ausführungsform vorgesehen, daß die Leuchtmittel durch ein zweites transparentes Substrat geschützt werden. Die Leuchtdioden liegen dann zwischen dem transparenten Trägersubstrat und dem weiteren transparenten Substrat. Auf diese Art und Weise können die Lichtquellen zusätzlich vor Umgebungseinflüssen, wie Feuchtigkeit und mechanisches Abscheren, geschützt werden.

In einer besonders bevorzugten Ausführungsform ist vorgesehen, daß das weitere transparente Substrat ebenfalls mit einer leitfähigen, transparenten Schicht versehen ist. Dies ermöglicht es, die Leuchtdioden ohne Gehäuse direkt zwischen zwei leitenden Substraten zu kontaktieren. Anstelle einer Beschichtung auf einem transparenten Substrat kann auch eine leitende Kunststoffolie vorgesehen sein.

Das transparente Substrat kann sowohl ein Glas- wie auch ein Kunststoffsubstrat sein. Besonders bevorzugt ist es, wenn das Glassubstrat gehärtet und vorgespannt ist. Als besonders bevorzugte Gläser finden Kalk-Natron Gläser Verwendung.

In einer besonders bevorzugten Ausführungsform ist vorgesehen, mehrere Trägersubstrate mit Leuchtmitteln, z.B. Leuchtdioden untereinander zu verbinden und zu kontaktieren. Dies ermöglicht Trägersubstrate beliebiger Form. Denkbar sind auch dreidimensionale Objekte aus mehreren Trägersubstraten, beispielsweise ein Würfel oder eine Pyramide aus quadratischen und dreieckigen Grundplatten.

Neben dem Trägersubstrat für ein elektronisches Bauteil, insbesondere für Leuchtmittel wie beispielsweise Leuchtdioden, stellt die Erfindung auch ein derartiges elektronisches Bauteil sowie ein Verfahren zur Herstellung eines derartigen Bauteiles zur Verfügung.

Als Anwendung für das erfindungsgemäße Trägersubstrat, insbesondere eines LED-Moduls mit einem deratigen Trägersubstrat, kommen alle diejenigen Applikationen in Betracht, in denen eine Beleuchtung, Signalgebung, Informationsdarstellung oder ein dekorativer Effekt erzielt werden soll. Besonders bevorzugt ist es, derartige LED-Module in Möbeln und Vitrinenleuchten, zur Darstellung von Schriftzügen, Symbolen oder Grafiken, zur Innen- oder Außenbeleuchtung sowie zur Fluchtwegbeleuchtung zu verwenden. In einer besonders bevorzugten Anwendung finden derartige LED-Module im Automobilbereich Verwendung, beispielsweise als dritte Bremsleuchte am PKW, die direkt in die Heckleuchte integriert wird. Eine alternative Anwendung im Automobilbereich betrifft die Verwendung von LED-Modulen direkt auf der Armaturenabdeckung.

Die erfindungsgemäße LED-Module können auch in sogenannten Verbundsystemen, die ein Trägersubstrat umfassen, verwendet werden. Denkbar ist zum Beispiel ein resistives Touch Panel, auf dem die LED's montiert sind.

Die Erfindung ist anhand der Zeichnungen näher erläutert. Es zeigen:
- Figur 1: ein erfindungsgemäßes LED-Modul.
- Fig. 2a - 2d: den typischen Verfahrensablauf zur Herstellung eines LED- Moduls gemäß der Erfindung.
- Figur 3: ein LED-Modul mit aufgebrachtem weiterem elektrischem Bauelement.
- Figur 4: ein LED-Modul mit aufgebrachter Hybridschaltung.
- Figur 5: zwei LED-Module unterschiedlicher Struktur.
- Fig. 6 - 7: die Verbindung von LED-Modulen für zweidimensionale beziehungsweise dreidimensionale Geometrien.

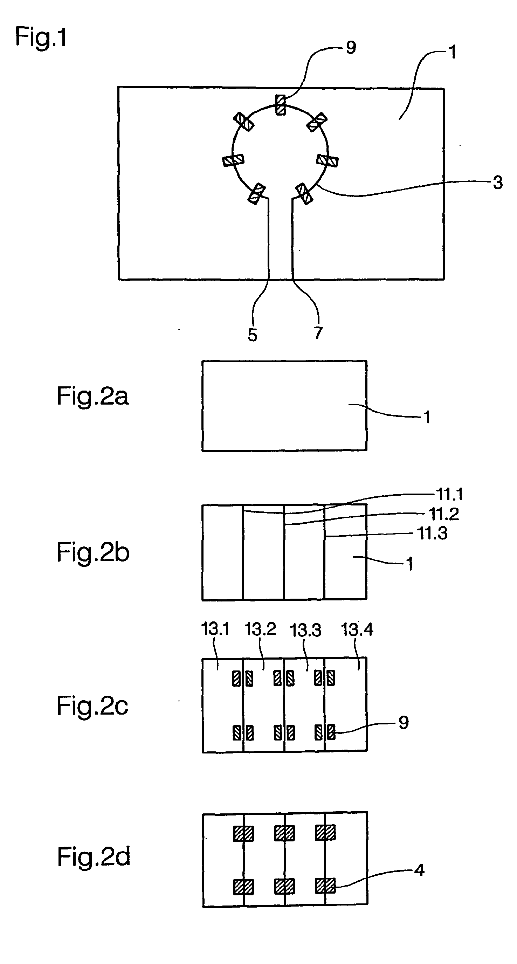

In Figur 1 ist ein Trägersubstrat gemäß der Erfindung mit auf das Trägersubstrat aufgebrachter leitfähiger Schicht dargestellt, die wiederum derart strukturiert wurde, daß auf dem transparenten Trägersubstrat 1 eine kreisförmige Leiterbahn 3 mit Anschlußleiter 5, 7 ausgebildet wird. Auf der kreisförmigen Leiterbahn 3 sind einzelne Anschlußstellen 9 angeordnet. Die Anschlußstellen 9 dienen dazu, die einzelnen Leuchtmittel, beispielsweise die Leuchtdioden 4 leitend mit der Leiterbahn zu verbinden und damit die Energieversorgung derselben sicherzustellen. Bevorzugt ist das Trägersubstrat ein Kalk-Natron Glas.

In den Figuren 2a bis 2d ist ein erfindungsgemäßer Verfahrensablauf zur Herstellung eines elektronischen Bauteiles, insbesondere eines LED-Moduls dargestellt. Zunächst wird das transparente Trägersubstrat 1 mt einer leitfähigen Schicht vollflächig beschichtet, beispielsweise im Sol-Gel-Verfahren.

Anschließend wird gemäß Figur 2b eine Strukturierung beispielsweise mittels Laser, der lokal die Beschichtung erhitzt und diese verdampft, hergestellt. Bevorzugt umfassen die Trägersubstrate, die mit Hilfe eines Lasers strukturiert werden eine leitfähigen Schicht, die im Bereich der Laserwellenlänge des eingesetzten Lasers eine hohe Absorption aufweisen und ein Substrat, welches bei dieser Wellenlänge transmissiv ist. Bei einem derartigen System weist die Glasschicht nur geringe Verletzungen auf. Insbesondere kann die Rißbildung bei derartigen Systemen weitgehend vermieden werden.

Die Kennlinien der einzelnen Bereiche des Substrates sind in Figur 2b mit den Bezugsziffern 11.1 - 11.3 bezeichnet. An die Strukturierung gemäß Figur 2b anschließend werden in den Bereichen 13.1 - 13.4 einzelne Anschlußstellen, sogenannte Anschlußpads 9 aufgebracht. Die Anschlußpads 9 umfassen eine leitende Paste oder Lack, beispielsweise Silberleitlack oder Silberpaste und wird mittels Siebdruck oder Schablonendruck auf das leitfähige Substrat aufgebracht und anschließend eingebrannt. Durch das Einbrennen kann gleichzeitig ein Vorspannen des transparenten Substrates, insbesondere des transparenten Glassubstrates erfolgen. Hierdurch wird eine hohe mechanische Festigkeit in einem einzelnen Verfahrensschritt erzielt.

Nach Aufbringen der Kontakte in den unterschiedlichen Bereichen 13.1 - 13.4 werden diese, wie in Figur 2d dargestellt, mit einem Standardverfahren bestückt, indem beispielsweise Lötpaste auf die Anschlußpads 9, beispielsweise mittels Schablonendruck, aufgebracht wird. Die Leuchtdioden (LED's) 4 werden sodann auf die Trägerplatte aufgebracht, wobei ein ChipBonder verwendet werden kann, der die Leuchtdioden 4 vor dem Lötprozeß auf dem Trägermaterial befestigt. Nach Befestigen der einzelnen LED's wird das Trägersubstrat 1 mit den darauf befestigten Leuchtdioden durch einen Reflow-Ofen geschickt oder durch ein Wellenlötbad.

In einem Ausführungsbeispiel der Erfindung wird ein Glassubstrat, typischerweise ein Kalk-Natron-Glas, mit einem fluordotierten Zinnoxid beschichtet.

Das Aufbringen der Beschichtung geschiet wie folgt:
Ein Kalk-Natron-Glas als transparentes Substrat wird auf 500°C erhitzt. Sodann wird das Glas mit Monobutyizinnchlorid und Flußsäure in Ethanol besprüht, wobei die Sprühlösung die nachfolgende Zusammensetzung aufweist:

| | |
|---|---|
| Monobutylzinnchlorid | 70% |
| Ethanol | < 30% |
| Flußsäure | 0,4% |

Nach dem Besprühen umfasst das Kalk-Natronglas eine transparente, fluordotierte Zinnoxid-Schicht.

Die Beschichtung wird sodann mit einem Laser aufgetrennt. Mit Hilfe eines Rakels wird per Siebdruck eine Silberleitpaste, z.B. Cerdec SP 1248 aufgebracht. Die Paste Cerdec 1248 wird in einem Durchlaufofen bei 140°C für 2 min angetrocknet und dann durch eine Vorspannanlage bei ca. 700°C für ein Kalk Natron-Glas eingebrannt und vorgespannt. Anschließend wird handelsübliche Lötpaste per Schablonendruck aufgetragen und mit Leuchtdioden bestückt, beispielsweise NSCW 100 Leuchtdioden der Fa. Nichia. Beim folgenden Reflowlöten wird für 2 min das bestückte Substrat auf 120°C vorgeheizt und anschließend für 5 sek auf 235°C erhitzt. Daran anschließend wird langsam abgekühlt.

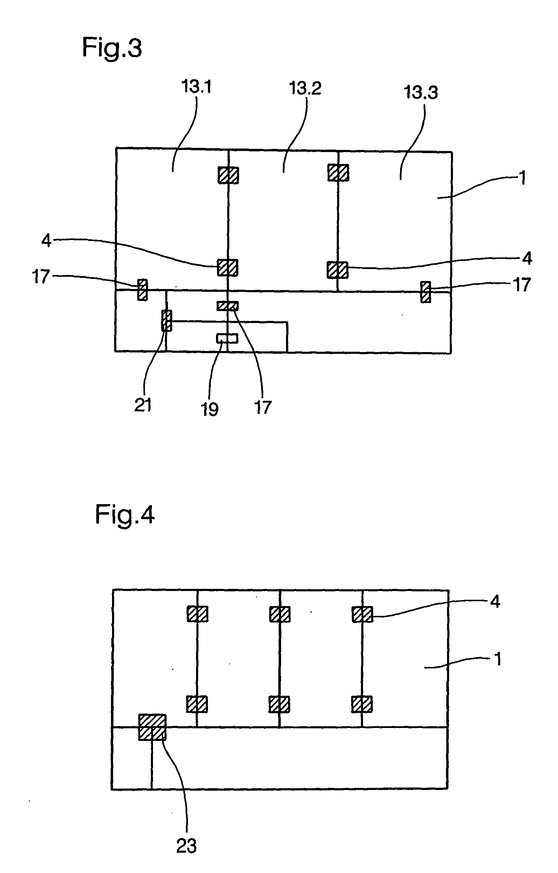

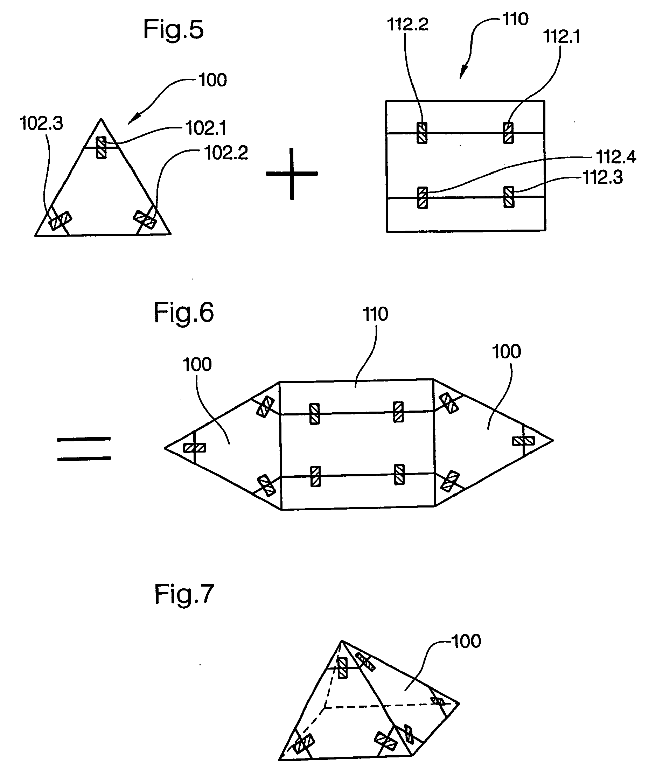

In Figur 3 ist eine Ausführungsform der Erfindung dargestellt, bei der ein transparentes Trägersubstrat 1 auf dem in unterschiedlichem Bereich 13.1, 13.2, 13.3, Leuchtdioden 4 mit Hilfe des in Figur 2a - 2d beschriebenen Verfahren aufgebracht wurde. Neben den Leuchtdioden 4 enthält das Trägersubstrat auch weitere elektronische Bauelemente, beispielsweise Widerstände 17, eine Halbleiterdiode 19 sowie einen Transistor 21. Anstelle von einzelnen Bauteilen können, wie in Figur 4 dargestellt, neben den Leuchtdioden 4 auch ganze elektronische Schaltkreise auf dem erfindungsgemäßen Trägersubstrat angeordnet werden. Gleiche Bauteile wie in den vorangegangenen Figuren sind auch in Figur 4 mit denselben Bezugsziffern belegt. Der elektronische Schaltkreis, beispielsweise die elektrische Ansteuerung oder Stromquelle ist mit der Bezugsziffer 23 belegt. Die vielseitige Verwendbarkeit der Erfindung geht aus den Figuren 5 - 7 hervor. In Figur 5 sind zwei LED-Module unterschiedlicher geometrischer Ausprägung dargestellt und zwar ein dreieckiges Modul 100 mit drei Leuchtdioden 102.1 - 102.3 sowie ein rechteckiges LED-Modul 110 mit Leuchtdioden 112.1 - 112.4.

Die geometrisch unterschiedlichen LED-Module 100, 110 können wie in Figur 6 dargestellt, in einer flachen Konfiguration zu einem LED-Modul beliebiger zweidimensionaler geometrischen Form verbunden werden sowie zu dreidimensionalen Strukturen wie in Figur 7 gezeigt. Durch Formgebung des Substrates vor der Beschichtung mit einer leitfähigen Schicht können beliebige dreidimensionale Strukturen , beispielsweise auch gebogene Strukturen hergestellt werden.

Mit der Erfindung wird erstmals ein Trägersubstrat angegeben, dessen leitende Schicht im Gegensatz zum Stand der Technik vollständig transparent und nicht undurchsichtig ist. Insbesondere erlaubt es das erfindungsgemäße Verfahren in einem einzigen Prozeßschritt beim Einbrennen der Anschlußstelle beziehungsweise Lötpads die Gläser gleichzeitig vorzuspannen. Durch die freie Strukturierbarkeit vollflächig beschichteter Gläser ist es möglich, auf einfache Art und Weise andere elektronische Bauelemente auf dem Trägersubstrat der LED-Module zu integrieren, beispielsweise die Ansteuerelektronik. Die Strukturierung kann unabhängig von der Beschichtung mit einer leitfähigen Schicht erfolgen. Durch das Aufbringen von Anschlußstellen ist es in einer besonders vorteilhaften Ausgestaltung der Erfindung möglich, Lötverbindungen auf ein transparentes Trägersubstrat aufzubringen. Ein weiterer Vorteil ist, daß sich durch das Zusammenfügen beliebiger Substratformen, Färbungen und von Dekorationsdruck sich beliebige geometrische Formen realisieren lassen.

Die vorliegende Erfindung umfasst die Aspekte, die in den nachfolgenden Sätzen niedergelegt sind, die einen Teil der Beschreibung darstellen, aber keine Ansprüche in Übereinstimmung mit der Entscheidung **J15/88 der Beschwerdekammer** sind:

### Sätze:

1. Trägersubstrat für elektronische Bauteile, insbesondere Leuchtmittel, die auf einer Fläche des Trägersubstrates aufgebracht sind mit
   1.1 einem transparenten Substrat (1)
   1.2 einer auf das transparente Substrat (1) aufgebrachten leitfähigen Schicht
      dadurch gekennzeichnet, dass
   1.3 die leitfähige Schicht im sichtbaren Wellenlängenbereich transparent oder quasitransparent und beliebig struktuierbar ist.
2. Trägersubstrat nach Satz 1, dadurch gekennzeichnet, dass die leitfähige Schicht ein Metalloxid umfasst.
3. Trägersubstrat nach Satz 2, dadurch gekennzeichnet, dass das Metalloxid eines oder mehrere der nachfolgenden Metalloxide umfasst:
   - InOₓ:Sn
   - SnOₓ:F
   - SnOₓ:Sb
   - ZnOₓ:Ga
   - ZnOₓ:B
   - ZnOₓ:F
   - ZnOₓ:Al
   - Ag/TiOₓ
4. Trägersubstrat nach Satz 3, dadurch gekennzeichnet, dass die leitfähige Schicht mit einem der nachfolgenden Verfahren:
   - CVD
   - PVD
   - Sprühpyrolyse
   - Sputtern
   - einem Sol-Gel-Verfahren
   auf das transparente Substrat (1) aufgebracht wird.
5. Trägersubstrat nach einem der Sätze 1 bis 2, dadurch gekennzeichnet, dass die leitfähige Schicht ein Metall umfasst.
6. Trägersubstrat nach Satz 5, dadurch gekennzeichnet, dass das Metall eines oder mehrere der nachfolgenden Metalle:

   Al, Ag, Au, Ni, Cr

   umfasst.
7. Trägersubstrat nach einem der Sätze 5 bis 6, dadurch gekennzeichnet, dass das Metall aufgedampft oder aufgesputtert wird.
8. Trägersubstrat nach einem der Sätze 1 bis 7, dadurch gekennzeichnet, dass das transparente Substrat (1) ein Glas- oder Kunststoffsubstrat ist.
9. Trägersubstrat nach Satz 8, dadurch gekennzeichnet, dass das Glassubstrat gehärtet und/oder vorgespannt ist.
10. Trägersubstrat nach einem der Sätze 8 bis 9, dadurch gekennzeichnet, dass das Glas- oder das Kunststoffsubstrat beliebige Kontur aufweist.
11. Trägersubstrat nach einem der Sätze 8 bis 10, dadurch gekennzeichnet, dass das Glas- oder Kunststoffsubstrat mit Dekordruck bedruckt ist.
12. Trägersubstrat nach einem der Sätze 1 bis 11, dadurch gekennzeichnet, dass die Strukturierung der Schicht durch eines oder mehrere der nachfolgenden Verfahren vorgenommen wird:
   - Strukturierung der vollflächig auf die Trägerplatte aufgebrachten leitfähigen Schicht mittels Laser durch Erhitzen und Verdampfen
   - Strukturieren mittels Lithographie und Ätztechnik der vollflächig aufgebrachten leitfähigen Schicht
   - Strukturierung mittels Maskentechnik, in dem die leitfähige Schicht durch eine vorbestimmte Maske aufgebracht wird.
13. Trägersubstrat nach einem der Sätze 1 bis 12, dadurch gekennzeichnet, dass die leitfähige Schicht derart ausgebildet ist, dass nach Aufbringen von Anschlussstellen aus leitender Paste oder Lack Bauteile auf das Trägersystem gelötet werden können.
14. Trägersubstrat nach einem der Sätze 1 bis 13, dadurch gekennzeichnet, dass dieses eine beliebige dreidimensionale Form aufweist.
15. Elektronisches Bauelement, insbesondere LED-Chip, dadurch gekennzeichnet, dass das Trägersubstrat für das Bauelement ein Trägersubstrat gemäß einem der Sätze 1 bis 14 umfasst.
16. Elektrisches Bauelement gemäß Satz 15, dadurch gekennzeichnet, dass zum Anschluss einzelner Baugruppen, insbesondere einzelner Leuchtdioden (4) auf die leitfähige Schicht Anschlussstellen (9), umfassend leitende Paste oder Lack, aufgebracht und anschließend eingebrannt werden.
17. Elektrisches Bauelement gemäß Satz 16, dadurch gekennzeichnet, dass die einzelnen Baugruppen mit einem Lötverfahren auf die Anschlussstellen (9) aufgebracht und damit leitend mit der leitfähigen Schicht verbunden werden.
18. Elektrisches Bauelement gemäß Satz 15, dadurch gekennzeichnet, dass die einzelnen Baugruppen mittels eines isotropen, leitenden Klebers auf dem Trägermaterial angeschlossen werden.
19. Elektrisches Bauelement nach einem der Sätze 15 bis 18, dadurch gekennzeichnet, dass das elektrische Bauelement eine oder mehrere der nachfolgenden Baugruppen umfasst:
   - Leuchtdioden
   - diskrete Halbleiter
   - passive und aktive Hauptgruppen
   - IC's
   - Widerstände
   - Kondensatoren
   - Spulen
20. Bauelement gemäß einem der Sätze 15 bis 19, dadurch gekennzeichnet, dass das Bauelement ein weiteres transparentes Substrat umfasst.
21. Bauelement gemäß Satz 20, dadurch gekennzeichnet, dass das weitere transparente Substrat über den auf dem Trägersubstrat aufgebrachten Baugruppen angeordnet ist, so dass die Baugruppen geschützt zwischen dem Trägersubstrat und dem weiteren transparenten Substrat liegen.
22. Bauelement nach Satz 20 oder 21, dadurch gekennzeichnet, dass das weitere transparente Substrat eine leitfähige transparente oder quasitransparente Schicht oder Folie umfasst.
23. Bauelement gemäß einem der Sätze 15 bis 22, dadurch gekennzeichnet, dass das Bauelement mehrere Trägersubstrate mit elektrischen oder elektronischen Bauelementen umfasst.
24. Verfahren zur Herstellung eines elektronischen Bauelementes mit einem Trägersubstrat gemäß einem der Sätze 1 bis 14, umfassend folgende Schritte:
   24.1 auf wenigstens ein transparentes Substrat wird eine transparente oder quasitransparente leitfähige Schicht entweder durch eine vorgegebene Maske strukturiert oder vollflächig aufgebracht;
   24.2 bei vollflächigem Aufbringen wird die leitfähige Schicht nach dem Aufbringen strukturiert;
   24.3 auf die strukturierte leitfähige Schicht werden Anschlussstellen oder isotrop leitender Kleber für den Anschluss der elektrischen Baugruppen auf der leitfähigen Schicht aufgebracht, wobei
   24.4 im Fall von Anschlussstellen die elektrischen Baugruppen mittels Lötverbindungen mit diesen leitend verbunden werden.
25. Verfahren nach Satz 24, dadurch gekennzeichnet, dass das Substrat vor Aufbringen der transparenten oder quasitransparenten Schicht beliebig dreidimensional geformt, insbesondere gebogen wird.
26. Verfahren nach Satz 24 oder 25, dadurch gekennzeichnet, dass der vollflächige Auftrag durch CVD- oder PVD-Verfahren, insbesondere Sprühpyrolyse, Sputtern oder der Sol-Gel-Technik aufgebracht wird.
27. Verfahren nach einem der Sätze 24 bis 26, dadurch gekennzeichnet, dass die Strukturierung der vollflächig aufgebrachten Schichten durch gezielte Unterbrechung dieser Schicht mittels Laser oder Lithographie und anschließenden Ätzprozessen vorgenommen wird.
28. Verfahren nach einem der Sätze 24 bis 27, dadurch gekennzeichnet, dass die Anschlussstellen aus einer leitenden Paste oder Lack mittels Siebdruck oder Schablonendruck aufgebracht und anschließend in das transparente Substrat eingebrannt werden, wobei das transparente Substrat vorgespannt wird.

## Patentansprüche

1. Trägersubstrat für elektronische Bauteile, insbesondere Leuchtmittel, die auf einer Fläche des Trägersubstrates aufgebracht sind mit
1.1 einem transparenten Substrat (1)
1.2 einer auf das transparente Substrat (1) aufgebrachten leitfähigen Schicht
**dadurch gekennzeichnet, dass**
1.3 die leitfähige Schicht im sichtbaren Wellenlängenbereich transparent oder quasitransparent und beliebig struktuierbar ist.

2. Trägersubstrat nach Anspruch 1, **dadurch gekennzeichnet, dass** die leitfähige Schicht ein Metalloxid umfasst.

3. Trägersubstrat nach Anspruch 2, **dadurch gekennzeichnet, dass** das Metalloxid eines oder mehrere der nachfolgenden Metalloxide umfasst:
- InOₓ:Sn
- SnOₓ:F
- SnOₓ:Sb
- ZnOₓ:Ga
- ZnOₓ:B
- ZnOₓ: F
- ZnOₓ:Al
- Ag/TiOₓ

4. Trägersubstrat nach Anspruch 3, **dadurch gekennzeichnet, dass** die leitfähige Schicht mit einem der nachfolgenden Verfahren:
- CVD
- PVD
- Sprühpyrolyse
- Sputtern
- einem Sol-Gel-Verfahren
auf das transparente Substrat (1) aufgebracht wird.

5. Trägersubstrat nach einem der Ansprüche 1 bis 2, **dadurch gekennzeichnet, dass** die leitfähige Schicht ein Metall umfasst.

6. Trägersubstrat nach Anspruch 5, **dadurch gekennzeichnet, dass** das Metall eines oder mehrere der nachfolgenden Metalle:
Al, Ag, Au, Ni, Cr
umfasst.

7. Trägersubstrat nach einem der Ansprüche 5 bis 6, **dadurch gekennzeichnet, dass** das Metall aufgedampft oder aufgesputtert wird.

8. Trägersubstrat nach einem der Ansprüche 1 bis 7, **dadurch gekennzeichnet, dass** das transparente Substrat (1) ein Glas- oder Kunststoffsubstrat ist.

9. Trägersubstrat nach Anspruch 8, **dadurch gekennzeichnet, dass** das Glassubstrat gehärtet und/oder vorgespannt ist.

10. Trägersubstrat nach einem der Ansprüche 8 bis 9, **dadurch gekennzeichnet, dass** das Glas- oder das Kunststoffsubstrat beliebige Kontur aufweist.

11. Trägersubstrat nach einem der Ansprüche 8 bis 10, **dadurch gekennzeichnet, dass** das Glas- oder Kunststoffsubstrat mit Dekordruck bedruckt ist.

12. Trägersubstrat nach einem der Ansprüche 1 bis 11, **dadurch gekennzeichnet, dass** die Strukturierung der Schicht durch eines oder mehrere der nachfolgenden Verfahren vorgenommen wird:
- Strukturierung der vollflächig auf die Trägerplatte aufgebrachten leitfähigen Schicht mittels Laser durch Erhitzen und Verdampfen
- Strukturieren mittels Lithographie und Ätztechnik der vollflächig aufgebrachten leitfähigen Schicht
- Strukturierung mittels Maskentechnik, in dem die leitfähige Schicht durch eine vorbestimmte Maske aufgebracht wird.

13. Trägersubstrat nach einem der Ansprüche 1 bis 12, **dadurch gekennzeichnet, dass** die leitfähige Schicht derart ausgebildet ist, dass nach Aufbringen von Anschlussstellen aus leitender Paste oder Lack Bauteile auf das Trägersystem gelötet werden können.

14. Trägersubstrat nach einem der Ansprüche 1 bis 13, **dadurch gekennzeichnet, dass** dieses eine beliebige dreidimensionale Form aufweist.

## Geänderte Patentansprüche

### Geänderte Patentansprüche gemäss Regel 137(2) EPÜ.

**1.** Trägersubstrat für elektronische Bauteile, insbesondere Leuchtmittel, die auf einer Fläche des Trägersubstrates aufgebracht sind mit
- einem transparenten Substrat (1);
- einer auf das transparente Substrat (1) aufgebrachten leitfähigen Schicht, wobei
die leitfähige Schicht im sichtbaren Wellenlängenbereich eine Transmission >60% aufweist und beliebig strukturierbar ist;
**dadurch gekennzeichnet, dass**
die leitfähige Schicht ein Metalloxid umfasst und das Metalloxid eines oder mehrere der nachfolgenden Metalloxide aufweist:
- SnOₓ:F
- SnOₓ:Sb
- ZnOₓ:Ga
- ZnOₓ:B
- ZnOₓ:F
- ZnOₓ:Al
- Ag/TiOₓ

**2.** Trägersubstrat nach Anspruch 1, **dadurch gekennzeichnet, dass** das transparente Substrat (1) ein Glas- oder Kunststoffsubstrat ist.

**3.** Trägersubstrat nach Anspruch 2, **dadurch gekennzeichnet, dass** das Glassubstrat ein gehärtetes und/oder vorgespanntes Glassubstrat ist.

**4.** Trägersubstrat nach einem der Ansprüche 2 bis 3, **dadurch gekennzeichnet, dass** das Glas- oder das Kunststoffsubstrat beliebige Kontur aufweist.

**5.** Trägersubstrat nach einem der Ansprüche 2 bis 4, **dadurch gekennzeichnet, dass** das Glas- oder Kunststoffsubstrat ein mit Dekordruck bedrucktes Glasund Kunststoffsubstrat ist.

**6.** Trägersubstrat nach einem der Ansprüche 1 bis 5, **dadurch gekennzeichnet, dass** die leitfähige Schicht eine laserstrukturierte Schicht ist.

**7.** Trägersubstrat nach einem der Ansprüche 1 bis 5, **dadurch gekennzeichnet, dass** die leitfähige Schicht eine lithographisch strukturierte Schicht ist.

**8.** Trägersubstrat nach einem der Ansprüche 1 bis 5, **dadurch gekennzeichnet, dass** die leitfähige Schicht eine maskenstrukturierte Schicht ist.

**9.** Trägersubstrat nach einem der Ansprüche 1 bis 8, **dadurch gekennzeichnet, dass** die leitfähige Schicht Anschlussstellen aus leitender Paste oder Lack für die elektronischen Bauteile umfasst.

**10.** Trägersubstrat nach einem der Ansprüche 1 bis 8, **dadurch gekennzeichnet, dass** das Trägersubstrat eine dreidimensionale Form ist.
